# EUROPÄISCHE PATENTANMELDUNG

(11) **EP 1 164 381 A2**
(43) Veröffentlichungstag der Anmeldung: **19.12.2001**
(21) Anmeldenummer: 01112141.5
(22) Anmeldetag: 17.05.2001
(51) Int. Cl.: G01R 31/316

(54) **Integrierte Schaltung mit Testbetrieb und Testanordnung zum Testen einer integrierten Schaltung**

(30) Priorität: 16.06.2000 DE 10029835
(71) Anmelder: Infineon Technologies AG, 81669 München (DE)
(72) Erfinder: Bette, Alexander, 81679 München (DE)
(74) Vertreter: Epping Hermann & Fischer

(57) **Zusammenfassung**

Während des Funktionstests einer integrierten Schaltung (2) ist diese mit einem Testautomaten (1) verbunden. Ein ausschließlich nur zur Zuführung einer zusätzlichen Versorgungsspannung (VTEST) vorgesehenes Anschlußpad (36) ist mit einem Versorgungsspannungsanschluß (26) des Testautomaten (1) verbunden. Ein im Testbetrieb schaltbarer Schalter (38) verbindet das Anschlußpad (36) zur Ansteuerung irreversibel programmierbarer Schalter (42, 43). Dadurch wird der Aufwand zur Zuführung einer Programmierspannung für die Schaltelemente (42, 43) gering gehalten.

## Beschreibung

Die Erfindung betrifft eine integrierte Schaltung mit Anschlußflächen für Pole einer Versorgungsspannung, die in einem Testbetrieb und einem Normalbetrieb betreibbar ist. Die Erfindung betrifft außerdem eine Testanordnung zum Testen einer solchen Schaltung.

Am Ende der Herstellung einer integrierten Schaltung wird diese funktionsmäßig getestet. Hierzu wird die integrierte Schaltung mit einem Testautomaten verbunden. Die Schaltung wird vom Testautomaten mit Versorgungsspannung gespeist und gemäß einem vorgegebenen Testprogramm mit Signalen versorgt. Je nach Schaltungstyp sind auch von der Betriebsversorgungsspannung abweichende Spannungseinprägungen vorzunehmen.

Insbesondere Halbleiterspeicher weisen redundante Strukturen auf, so daß fehlerhafte Bauelemente oder Speicherzelle dadurch ersetzt werden können. Anstelle der fehlerhaften Struktur wird die redundante Struktur geschaltet. Die Umschaltung wird mittels irreversibler Schalter, sogenannten Fuses, bewirkt. Zum Programmieren einer Fuse wird eine höhere, außerhalb des Betriebsspannungsbereichs liegende Spannung benötigt. Beispielsweise beträgt die Betriebsspannung des Halbleiterspeichers 3 Volt, zum Programmieren der Fuse sind 6 Volt erforderlich.

Der Testautomat weist jeweilige Anschlüsse für Versorgungsspannung und zu verarbeitende Signale auf. Bei üblichen Testautomaten sind die Anschlüsse für eine oder mehrere Versorgungsspannungen unabhängig voneinander steuerbar und können Spannungen weitgehend beliebiger Höhe liefern. Die zur Signalversorgung der zu testenden Schaltung vorgesehenen Anschlüsse hingegen sind zwar bezüglich ihres Signalzustands einzeln steuerbar, die Höhe der Signalspannung ist jedoch nur gruppenweise für eine Vielzahl von Signalanschlüssen einstellbar. Zur Zuführung der zur Programmierung einer Fuse erforderlichen erhöhten Spannung ist es nicht ratsam, einen Signalanschluß zu verwenden, da dann die gesamte Gruppe von Signalanschlüssen des Testers diese erhöhte Spannung führen müßte. Auf Seite des zu testenden Halbleiterspeichers würde eine zu hohe Spannungsbelastung der Signalanschlüsse vorliegen, so daß die Schaltung einem unnötig hohen Belastungs- und Alterungsstreß ausgesetzt wäre. Im ungünstigsten Fall könnten Halbleiterstrukturen zerstört werden. Andererseits könnte zwar halbleiterspeicherintern ein Spannungsgenerator vorgesehen werden. Dies erforderte jedoch erhöhten Flächenverbrauch auf dem Halbleiterchip.

Eine Aufgabe der Erfindung besteht darin, eine integrierte Schaltung anzugeben, bei der die Zuführung einer weiteren Versorgungsspannung im Testbetrieb mit geringem Aufwand ermöglicht wird. Eine weitere Aufgabe besteht darin, eine Testanordnung mit einem Testautomaten zum Testen einer solchen integrierten Schaltung anzugeben.

Betreffend die integrierte Schaltung wird diese Aufgabe gelöst durch eine integrierte Schaltung, umfassend: erste Anschlußflächen für je einen von zwei Polen einer Versorgungsspannung, eine zweite Anschlußfläche, die signalmäßig ausschließlich mit nur einem Schalter verbunden ist, der von einem Testsignal ansteuerbar ist, so daß in einem Testbetrieb der Schaltung der Schalter geschlossen ist und in einem Normalbetrieb der Schalter geöffnet ist, und eine Funktionseinheit mit durch Spannungseinprägung irreversibel schaltbaren Elementen, deren Anschluß zum Einprägen einer Spannung mit einem Schalter gekoppelt ist.

Eine Testanordnung zum Testen einer integrierten Schaltung umfaßt einen Testautomaten, der Anschlüsse zur Zuführung eines Pols einer Versorgungsspannung und eine Anzahl von Anschlüssen zur Zuführung mehrerer Zustände umfassende Signale aufweist, und umfaßt eine integrierte Schaltung gemäß der Erfindung, wobei die zweite Anschlußfläche mit einem Anschluß zur Zuführung eines Pols einer Versorgungsspannung des Testautomaten verbunden ist.

So ist auf der integrierten Schaltung eine zusätzliche Anschlußfläche vorgesehen, die nur zur Einspeisung der von der Betriebsversorgungsspannung abweichenden Versorgungsspannung im Testbetrieb dient. Bei integrierten Schaltungen, insbesondere Halbleiterspeichern, sind je nach der Größe des Gehäuses oftmals Anschlußstifte oder -pads vorhanden, die für den Normalbetrieb ohne Funktion sind. sie können daher speziell für den Testbetrieb verwendet werden. Es besteht zwar bei integrierten Schaltungen das Bestreben, Chipfläche und insbesondere auch Anschlüsse zu sparen. Wenn jedoch Anschlußflächen auf freien Bereichen des Chips noch ohne weiteres anordenbar sind und das Gehäuse aufgrund der standardisierten Größe für den Normalbetrieb funktionslos geschaltete Anschlußstifte hat, dann kann eine solche Anschlußfläche und der damit verbundene Anschlußstift speziell nur für den Testbetrieb zu Zuführung einer weiteren Versorgungsspannung benutzt werden. Ein solcher nur für den Testbetrieb verwendbarer Versorgungspin hat den Vorteil, daß er im Testautomaten an einen dedizierten Versorgungsspannungsanschluß angeschlossen werden kann. Ein solcher Anschluß des Testautomaten ist individuell in der Höhe der zu erzeugenden Versorgungsspannung einstellbar. Er unterscheidet sich dadurch wesentlich von einem Signalanschluß, dessen Signalpegelhöhe im allgemeinen nur gruppenweise einstellbar ist.

Erforderlich ist außerdem, daß diese Anschlußfläche im Normalbetrieb sicher und vollständig abgeschaltet ist. Hierzu ist ein Schalter vorgesehen, der im Testbetrieb leitend geschaltet ist, so daß die zuführbare weitere Versorgungsspannung ins Schaltungsinnere, z.B. zum Programmieren von Fuses, weitergeleitet wird, im Normalbetrieb jedoch sicher geöffnet ist, so daß jegliches anliegende Signal nicht ins Schaltungsinnere weitergeleitet wird. Gegebenenfalls ist im Datenblatt des integrierten Schaltkreises ausdrücklich zu vermerken, daß der betreffende Anschlußpin des Gehäuses für den Normalbetrieb keine Funktion hat, aber trotzdem nicht vollkommen unbeschaltet ist. Insbesondere ist die chipseitige Anschlußfläche mit geeigneten Schaltungen zur Ableitung von ESD-Impulsen (ESD: Electrostatic Discharge) zu versehen.

Die zusätzlich zuführbare Versorgungsspannung weicht von der üblichen Betriebsspannung ab. Sie kann niedriger oder vorzugsweise höher, d.h. betragsmäßig größer als die Versorgungsspannung im Normalbetrieb sein. Die zusätzliche Versorgungsspannung dient zum Programmieren eines irreversibel schaltbaren Schaltelements. Solche Schaltelemente sind beispielsweise Fuses, die im Ausgangszustand leitend sind und im einmalig und irreversibel programmierten Zustand einen Leerlauf darstellen. Alternativ sind auch Antifuses denkbar, die im Ausgangszustand einen Leerlauf darstellen und im programmierten Zustand leitend sind. Solche Fuses bzw. Antifuses dienen dazu, um an Speicherelemente bei der Initialisierung der integrierten Schaltung Signalzustände einzuprägen. Bei Halbleiterspeichern werden mittels solcher Fuses Signalpfade geschaltet, mit denen fehlerhafte Bauelemente durch redundant vorhandene fehlerfreie Bauelemente ersetzt werden. Beispielsweise werden defekte Speicherzellen oder Gruppen von Speicherzellen durch redundant vorhandene Speicherzellen bzw. Gruppen von Speicherzellen ersetzt.

Eine Testanordnung zum Testen einer oben beschriebenen integrierten Schaltung, insbesondere eines integrierten Halbleiterspeichers, umfaßt einen Testautomaten welcher Anschlüsse sowohl zur Zuführung von Versorgungsspannung als auch zur Zuführung von Betriebssignalen aufweist. Versorgungsspannungsanschlüsse sind automatenseitig einzeln bezüglich der Höhe der einzuprägenden Spannung steuerbar. Die Betriebssignale sind zwar einzeln bezüglich ihres jeweiligen Signalzustands steuerbar. Die Pegelhöhe für die jeweiligen Zustände ist jedoch nur signalgruppenweise einstellbar. Ein Versorgungsspannungsanschluß des Testers ist daher mit dem zusätzlichen zur Programmierung der Fuse dienenden Versorgungsspannungsanschlusses der zu testenden integrierten Schaltung verbunden. Bei einem Testvorgang werden üblicherweise eine Vielzahl von integrierten Schaltungen getestet. Diese sind auf einer Testplatine angeordnet. Die zusätzlichen Versorgungsanschlüsse zur Bereitstellung der Spannungseinprägung für die Programmierung der Fuses werden für die Vielzahl der zu testenden integrierten Schaltung miteinander verdrahtet. Dadurch liegt die zusätzliche Spannungseinprägung an jedem dementsprechenden Spannungspin aller zu testenden integrierten Schaltungen an. Abhängig von den weiteren den jeweiligen Schaltungen zuführbaren Signalen wird dann zeitgerecht ein Signalpfad chipintern geschaltet, um die erhöhte Spannungseinprägung einer entsprechenden Fuse zuzuführen, um sie zu programmieren. Darüber hinaus kann der zusätzliche Versorgungsspannungsanschluß vorgesehen werden, um jedwede beliebige Spannung, beispielsweise als Referenzspannungseinprägung an die zu testenden integrierten Schaltungen zuzuführen.

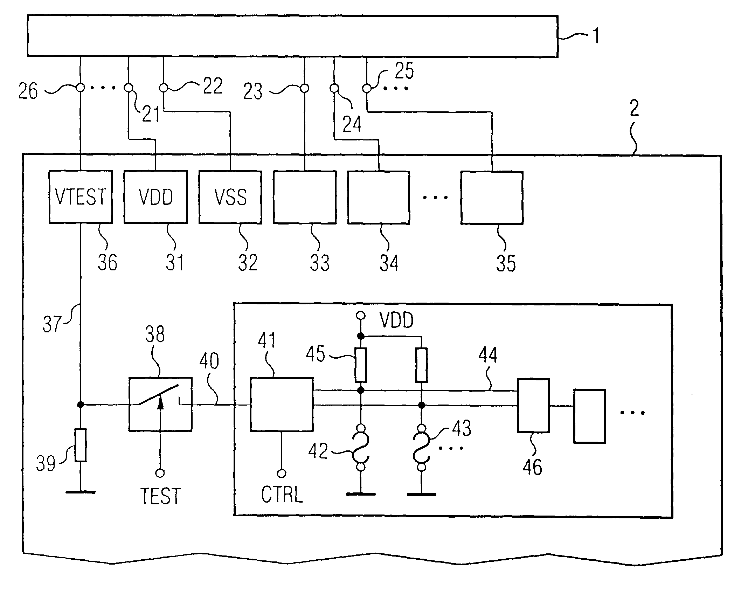

Nachfolgend wird die Erfindung anhand der in der Zeichnung dargestellten Figur näher erläutert. Die Figur zeigt einen Testautomaten 1 sowie eine zu testende integrierte Halbleiterschaltung 2. Die Halbleiterschaltung 2 weist Anschlußflächen, sogenannte Pads, auf, über die die Signale dem Halbleiterchip zuführbar sind. Die Pads sind flächige Metallisierungen, die von der Oberfläche des Chips her zugänglich sind. Mittels eines Bonddrahts, der auf die Pads aufgestempelt wird, wird jedes Pad mit einem Anschlußstift, der am Gehäuse angebracht ist und von außerhalb des Gehäuses zugänglich ist, verbunden. Die integrierte Schaltung 2 weist ein (oder mehrere) Pads 31 für den positiven Pol VDD der Versorgungsspannung auf sowie ein (oder mehrere) Pads 32 zur Zuführung des negativen Pols VSS der Versorgungsspannung (Masse) auf. Von den Pads 31, 32 aus wird im Normalbetrieb die Versorgung der integrierten Halbleiterschaltung mit Betriebsspannung bewirkt. Darüber hinaus sind eine Vielzahl von Signalpads 33, 34, 35 vorgesehen, durch die den Signalzustand wechselnde Betriebssignale zuführbar und abgreifbar sind. Die Signalpegel für High- und Low-Pegelzustände sind bei den über die Pads 33, 34, 35 geführten Signalen jeweils gleich.

Außerdem ist ein Pad 36 angeordnet. Das Pad 36 ist über eine einzige Leitung 37 mit einer Schalteinrichtung 38 verbunden. Die Schalteinrichtung 38 ist von einem Signal TEST steuerbar, welches angibt, daß sich die integrierte Schaltung im Testzustand befindet. Beispielsweise wird das Signal TEST durch eine speziell kodierte Signalfolge über die an den Pads 33, 34, 35 eingegebenen Betriebssignale erzeugt. Bei aktiviertem Signal TEST ist die Schalteinrichtung 38 geschlossen und bildet einen leitenden Pfad, durch den die Spannungseinprägung am Pad 36 über die Leitung 37 weiter in das Schaltungsinnere der integrierten Schaltung 2 geführt wird. Außer durch die Leitung 37 ist das Pad 36 nicht weiter beschaltet. Insbesondere wird das Pad 36 nicht zur Eingabe von Betriebssignalen, vergleichbar der Pads 33, 34, 35, zusätzlich verwendet. Das Pad 36 dient ausschließlich nur zur Zuführung einer Spannungseinprägung VTEST. Während des Tests der integrierten Schaltung wird diese Versorgungsspannung an das Schaltungsinnere weitergeleitet, während des ansonsten laufenden Normalbetriebs ist der Schalter 38 geöffnet, so daß ein etwaiges am Pad 36 eingegebenes Signal über einen Pull-Down-Widerstand 39 nach Masse abgeführt wird. Die über das Pin 36 einkoppelbare Spannung VTEST ist im gezeigten Ausführungsbeispiel so zu bemessen, daß sie bezüglich Bezugsspannung VSS höher liegt als das Betriebsversorgungspotential VDD.

Im Testbetrieb wird die ausgangsseitige Leitung 40 des Schalters 38 mit erhöhter Betriebsspannung gespeist. Diese Betriebsspannung wird verwendet, um irreversibel schaltbare Schalter 42, 43, sogenannte Fuses, zu programmieren. Eine Fuse bildet im Ausgangszustand eine leitende Verbindung, so daß die an die Fuse 42 angeschlossene Leitung 44 mit Masse verbunden ist. Wenn eine außerhalb der Normalbetriebsspannung liegende Spannung in der Höhe von beispielsweise 6 Volt oder darüber an die Fuse 42 ausreichend lange angelegt, so wird die Fuse 42 durchtrennt. Die Leitung 44 wird dann über einen Pull-Up-Widerstand 45 an das positive Versorgungspotential VDD gelegt. Durch die Leitung 44 wird der Eingang einer Registerzelle 46 angesteuert, welche weitere Schaltvorgänge in der integrierten Schaltung ausführt. Beispielsweise dient das Ausgangssignal der Registerzelle 46 dazu, defekte Speicherzellen durch redundante Speicherzellen zu ersetzen. Um die über das Pad 36 eingegebene erhöhte Spannung zeitrichtig auf eine jeweilige Fuse 42, 43 zu schalten, ist eine Teststeuerungseinrichtung 41 vorgesehen, welche entsprechend der Fehler- und Redündanzinformation von einem mehrere Bits umfassenden Steuersignal CTRL gesteuert wird.

Der Testautomat 1 weist den jeweiligen Anschlüssen 31, ..., 36 zugeordnete Anschlüsse 21, ..., 26 auf. Die Anschlüsse 21, 22 sind derart ausgeführt, daß sie niederohmig eine Versorgungsspannung beliebiger, individuell einstellbare Höhe zur Verfügung stellen. Die Anschlüsse 23, 24, 25, stellen Betriebssignale bereit, welche bezüglich der Höhe der Signalpegel nur gruppenweise einstellbar sind. Bemerkenswert ist, daß der Anschluß 36 für die Programmierspannung mit einem den Anschlüssen 21, 22 vergleichbaren Versorgungsspannungsanschluß 26 des Testautomaten 1 verbunden ist. Dieser Anschluß ist im Hinblick auf die von ihm bereitstellbare Versorgungsspannung beliebig und individuell konfigurierbar.

Dadurch wird unter der Voraussetzung, daß das Pad 36 im Normalbetrieb unverbunden und funktionslos wäre, eine Lösung geschaffen, die mit geringem Aufwand die Bereitstellung einer von der Betriebsspannung abweichenden Spannung im Testbetrieb ermöglicht.

## Patentansprüche

1. Integrierte Schaltung, umfassend:
- erste Anschlußflächen (31, 32) für je einen von zwei Polen einer Versorgungsspannung (VDD, VSS),
- eine zweite Anschlußfläche (36), die signalmäßig ausschließlich mit nur einem Schalter (38) verbunden ist, der von einem Testsignal (TEST) ansteuerbar ist, so daß in einem Testbetrieb der Schaltung der Schalter (38) geschlossen ist und in einem Normalbetrieb der Schalter (38) geöffnet ist, und
- eine Funktionseinheit mit durch Spannungseinprägung irreversibel schaltbaren Elementen (42, 43), deren Anschluß zum Einprägen einer Spannung (VTEST) mit dem Schalter (38) gekoppelt ist.

2. Integrierte Schaltung nach Anspruch 1,
**dadurch gekennzeichnet, daß**
eines der durch Spannungseinprägung irreversibel schaltbaren Elemente (42, 43) im Ausgangszustand einen leitenden Strompfad bildet und nach erfolgter Spannungseinprägung einen leerlaufenden Strompfad bildet.

3. Integrierte Schaltung nach Anspruch 1 oder 2,
**dadurch gekennzeichnet, daß**
die zum irreversiblen Schalten des Elements (42, 43) erforderliche Spannung (VTEST) von der Versorgungsspannung (VDD, VSS) abweicht.

4. Integrierte Schaltung nach Anspruch 3,
**dadurch gekennzeichnet, daß**
die erforderliche Spannung (VTEST) betragsmäßig größer ist als die Versorgungsspannung (VDD, VSS).

5. Testanordnung zum Testen einer integrierten Schaltung (2), umfassend einen Testautomaten (1), der Anschlüsse (21, 22, 26) zur Zuführung eines Pols einer Versorgungsspannung (VDD, VSS, VTEST) und eine Anzahl von Anschlüssen (23, 24, 25) zur Zuführung mehrerer Zustände umfassende Signale aufweist, und umfassend eine integrierte Schaltung (2) nach einem der Ansprüche 1 bis 4, wobei die zweite Anschlußfläche (36) mit einem Anschluß (26) zur Zuführung eines Pols (VTEST) einer Versorgungsspannung des Testautomaten (1) verbunden ist.
